(19) Europäisches Patentamt
European Patent Office
Office européen des brevets

(11) **EP 4 459 524 A1**

(12) **EUROPEAN PATENT APPLICATION**
published in accordance with Art. 153(4) EPC

(43) Date of publication:
06.11.2024 Bulletin 2024/45

(51) International Patent Classification (IPC):
*G06Q 10/06* (2023.01)          *G06Q 50/04* (2012.01)
*H01L 21/67* (2006.01)

(21) Application number: 22913942.3

(52) Cooperative Patent Classification (CPC):
Y02P 90/30

(22) Date of filing: 25.11.2022

(86) International application number:
PCT/CN2022/134416

(87) International publication number:
WO 2023/124684 (06.07.2023 Gazette 2023/27)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.12.2021 CN 202111636432

(71) Applicants:
• Xi'An Naura Microelectronics Equipment Co.,
Ltd.
Xi'an, Shaanxi 710075 (CN)

• Beijing NAURA Microelectronics Equipment Co.,
Ltd.
Beijing 100176 (CN)

(72) Inventor: YANG, Guang
Beijing 100176 (CN)

(74) Representative: Cohausz & Florack
Patent- & Rechtsanwälte
Partnerschaftsgesellschaft mbB
Bleichstraße 14
40211 Düsseldorf (DE)

(54) **TASK SCHEDULING METHOD AND SEMICONDUCTOR PROCESS DEVICE**

(57)    An embodiment of the present disclosure provides a task scheduling method, including: acquiring task data of all to-be-started tasks, with the task data including procedure numbers, processing durations, processing positions, and processing-position stop durations corresponding to all procedures corresponding to the to-be-started tasks; inputting the task data of each to-be-started task to a task scheduling model to obtain a start moment of each to-be-started task which is output by the task scheduling model, with the task scheduling model taking minimizing total time required for performing all the to-be-started tasks as an objective function, and constraint conditions of the task scheduling model being associated with the task data; and performing task scheduling on the to-be-started tasks according to the start moment of each to-be-started task. According to the embodiment of the present disclosure, task completion efficiency can be increased, which can further improve equipment production capacity.

acquire task data of all to-be-started tasks, with the task data including procedure numbers, processing durations, processing positions, and processing-position stop durations corresponding to all procedures corresponding to the to-be-started tasks — 310

input the task data of each to-be-started task to a task scheduling model to obtain a start moment of each to-be-started task which is output by the task scheduling model, with the task scheduling model taking minimizing the total time required for performing all the to-be-started tasks as an objective function, and constraint conditions of the task scheduling model being associated with the task data — 320

perform task scheduling on the to-be-started tasks according to the start moment of each to-be-started task — 330

FIG. 3

**Description**

TECHNICAL FIELD

The present disclosure relates to the field of semiconductor technology, and in particular, to a task scheduling method and a semiconductor process device.

BACKGROUND

At present, with the development of automation technology, a plurality of tasks may be started in a semiconductor device. Based on existing technical solutions, when a task is being performed in the device, a task, which is compatible with the ongoing task and has waited for a longest time, will be selected from to-be-started tasks as a task to be started next. However, the existing technical solutions can neither determine accurate time when the to-be-started task is started, nor achieve reasonable planning of a plurality of to-be-started tasks.

Therefore, current task scheduling methods fail to realize real-time optimization of task scheduling and cause resource waste, resulting in low equipment production capacity.

SUMMARY

A technical problem to be solved by embodiments of the present disclosure is low equipment production capacity.

In order to solve the above problem, an embodiment of the present disclosure discloses a task scheduling method applied to a semiconductor process device, the semiconductor process device processes a plurality of materials in a same batch of processes, each of the materials corresponds to one to-be-started task, each of to-be-started tasks includes a plurality of procedures, and the task scheduling method includes:

acquiring task data of all the to-be-started tasks; wherein the task data includes procedure numbers, processing durations, processing positions, and processing-position stop durations corresponding to all the procedures corresponding to the to-be-started tasks, a procedure number is a procedure code, a processing duration is time required for completing each of the procedures, a processing position is a position of a material in the semiconductor process device when each of the procedures is performed, and a processing-position stop duration is a stop duration of a material at a corresponding processing position after each of the procedures is completed;

inputting the task data of each of the to-be-started tasks to a task scheduling model to obtain a start moment of each of the to-be-started tasks which is output by the task scheduling model; wherein the task scheduling model takes minimizing total time required for performing all the to-be-started tasks as an objective function, and constraint conditions of the task scheduling model are associated with the task data; and

performing task scheduling on the to-be-started tasks according to the start moment of each of the to-be-started tasks.

An embodiment of the present disclosure discloses a semiconductor process device, the semiconductor process device processes a plurality of materials in a same batch of processes, each of the materials corresponds to one to-be-started task, each of to-be-started tasks includes a plurality of procedures, and the semiconductor process device includes:

a controller, which is configured to acquire task data of all the to-be-started tasks;

wherein the task data includes procedure numbers, processing durations, processing positions, and processing-position stop durations corresponding to all the procedures corresponding to the to-be-started tasks, a procedure number is a procedure code, a processing duration is time required for completing each of the procedures, a processing position is a position of a material in the semiconductor process device when each of the procedures is performed, and a processing-position stop duration is a stop duration of a material at a corresponding processing position after each of the procedures is completed;

to input the task data of each of the to-be-started tasks to a task scheduling model to obtain a start moment of each of the to-be-started tasks which is output by the task scheduling model; wherein the task scheduling model takes minimizing total time required for performing all the to-be-started tasks as an objective function, and constraint conditions of the task scheduling model are associated with the task data; and

to perform task scheduling on the to-be-started tasks according to the start moment of each of the to-be-started tasks.

According to the embodiments of the present disclosure, the task data, which include the procedure numbers, the processing durations, the processing positions, and the processing-position stop durations corresponding to all the procedures corresponding to the to-be-started tasks, is acquired; and the task data is input to the task scheduling model which takes minimizing the total time required for performing all the to-be-started tasks as the objective function and has the constraint condition associated with the task data, so as to obtain the start moment of each to-be-started task which is output by the task scheduling model. Here, all the to-be-started tasks are planned by taking minimizing the total processing time as an objective, the start moment of each to-be-started task can be obtained according to the task data, the starting of the tasks can be planned efficiently and orderly. Finally, task scheduling is performed on the to-be-started tasks according to the start moments, which can increase task completion efficiency, thereby improving equipment production capacity.

BRIEF DESCRIPTION OF DRAWINGS

FIG. 1 is a schematic structural diagram of a semiconductor process device according to an embodiment of the present disclosure;
FIG. 2 is a flowchart of procedures of a task according to an embodiment of the present disclosure;
FIG. 3 is a flowchart illustrating a task scheduling method according to an embodiment of the present disclosure; and
FIG. 4 is a schematic structural diagram of a semiconductor process device according to an embodiment of the present disclosure.

DETAIL DESCRIPTION OF EMBODIMENTS

Features of all aspects and exemplary embodiments of the present disclosure are described in detail below. In order to make the objective, technical solutions and advantages of the present disclosure clearer, the present disclosure is further described in detail below in conjunction with the drawings and the specific embodiments. It should be understood that the specific embodiments described herein are merely intended to explain the present disclosure, rather than limiting the present disclosure. For those of ordinary skill in the art, the present disclosure may be implemented without some of the details described herein. The following description of the embodiments is merely intended to provide a better understanding of the present disclosure by illustrating examples of the present disclosure.

It should be further noted that the relational terms such as "first" and "second" herein are only used to distinguish one entity or action from another entity or action, and do not necessarily require or imply that such relationship or order actually exists between the entities or actions. Moreover, the terms "includes", "comprises" or any other variation thereof are intended to indicate a non-exclusive inclusion, so that a process, method, article, or device, which includes a series of elements, does not only include those listed elements but also include other elements which are not explicitly listed, or the elements inherent in such process, method, article, or device. If there are no more limitations, limiting an element by "including a..." does not exclude the existence of other identical elements in the process, method, article, or device which includes the element.

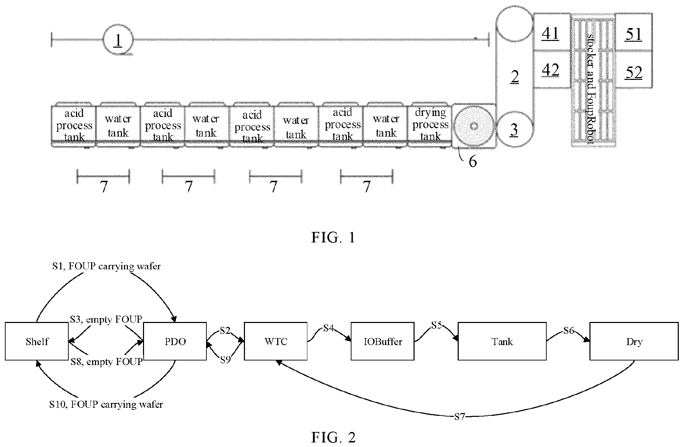

Firstly, a semiconductor process device involved in the present disclosure is briefly described with reference to FIG. 1.

The semiconductor process device involved in the present disclosure may be divided into a placement module (i.e., a station module), a processing module (i.e., a tank), a wafer box manipulator (i.e., a FoupRobot (FR)), one wafer grabbing manipulator (i.e., a Wafer Handling Robot (WHR)) 2, one wafer transferring manipulator (i.e., a Wafer Transferring Robot (WTR)) 1, and four dual-lifting manipulators (i.e., DualLifter Robots). A specific machine structure is shown in FIG. 1.

The semiconductor process device may include a plurality of station modules. For example, the semiconductor process device may include eighteen station modules, a set of which is expressed as ST={shelf1, shelf2, shelf3, shelf4, shelf5, shelf6, shelf7, shelf8, shelf9, shelf10, shelf11, shelf12, shelf13, shelf14, shelf15, shelf16, PDO1, PDO2}. A wafer holder (i.e., a shelf) is configured to temporarily store a wafer box (i.e., a Front Opening Unified Pod (FOUP)), and a group of wafers or chips may be stored in one FOUP. At most one FOUP may be placed on each shelf, and a sensor is provided on the shelf for detecting the number (0 or 1) of the FOUP. The semiconductor process device is provided with sixteen shelves capable of storing at most sixteen 16 FOUPs.

Two scanning modules (PDOs, including loading chambers (i.e., Load Locks (LLs) 41, 42) may be provided. The PDO is a module for opening and closing an FOUP door and performing a mapping function. When a material enters the machine and is placed on the PDO, the PDO executes a door opening operation and performs mapping verification on a wafer in an FOUP, so as to avoid material residues and abnormal placement of the wafer. In addition, the semiconductor process device may further include lower chambers 51, 52 (i.e., Lower Plenums (LPs) for loading and unloading of the wafers.

A storage unit (i.e., a stocker) may be provided and include sixteen shelves. The stocker is a buffer area for temporarily placing the FOUPs, at most sixteen FOUPs may be placed on the stocker, components of the stock for placing the FOUPs are called shelves, and each shelf is provided with a sensor to detect whether an FOUP exists currently. The components are mainly configured to support a multi-tasking function.

An FOUP is a container configured to protect, transfer, and store a wafer in a semiconductor process, and main components of the FOUP are a front opening container capable of accommodating the wafer and a front opening door frame for opening and closing the container. The FOUP is an important transfer container in an automatic transfer system.

The semiconductor process device includes a plurality of tanks that are disposed in sequence. For example, the semiconductor process device includes twelve tanks. The tank may also be called a process tank in the field of semiconductor process devices. A set of the twelve tanks is expressed as TK={Tank1(T1), Tank2(T2), Tank3(T3), Tank4(T4), Tank5(T5), Tank6(T6), Tank7(T7), Tank8(T8), Dry, WTC, IOBuffer, EEWD}.

The Dry is a drying unit configured to perform a drying process on a material to ensure that the material is dry after a process task (i.e., a job) is completed.

A verification module (i.e., the IOBuffer) 6 is configured to perform an align calibration operation on the material.

A temporary storage module (i.e., the WTC) 3 is configured to combine and place materials for a same task in a tank, so as to allow the materials to be processed together.

The EEWD is configured to perform a washing operation on a manipulator which grabs materials from different acid tanks, so as to reduce the pollution of the manipulator on acids in different acid process units.

The twelve tanks include the WTC, the IOBuffer (in which align calibration is performed), the EEWD (serving as a washing tank), and tanks for corresponding process operations. Illustratively, the Tank1, the Tank3, the Tank5, and the Tank7 are acid process tanks, the Tank2, the Tank4, the Tank6, and the Tank8 are water tanks, and the Dry is a drying process tank. Respective dual manipulators are provided between the Tank1 and the Tank2, between the Tank3 and the Tank4, between the Tank5 and the Tank6, and between the Tank7 and the Tank8. The transfer of the wafer between the tanks provided with the dual manipulator is carried out by the dual manipulator, and the transfer of the wafer among the other tanks is carried out by the WTR. Finally, the wafer is dried by the drying tank and is transferred out of the machine.

The semiconductor process device may include one FoupRobot, one WHR 2, one WTR 1, and a plurality of DualLifter Robots 7.

The FoupRobot (hereinafter referred to as an FR manipulator) is configured to transfer the FOUPs. The FoupRobot may move in both directions between a shelf and a PDO, and grab one FOUP at a time. The FoupRobot is mainly configured to perform the following operations in a task: transferring, after the task is started, the FOUP from the stocker to the PDO1 or the PDO2 according to a process path of the wafer, and transferring, after the task is ended, the FOUP to the stocker. The FoupRobot moves only in the areas of the PDO1, the PDO2, and the stocker.

The WHR 2 is a manipulator configured to transfer a dry material, and may move in both directions between a PDO and the WTC, and grab one group of wafers at a time. The WHR 2 is configured to grab a wafer from an FOUP on the PDO and move the wafer to the WTC. The WHR 2 moves only in the areas of the WTC and the PDO.

The WTR 1 is configured to transfer a wet material between the tanks which do not use the DualLifter Robots, and may move in both directions between two tanks which do not use the DualLifter Robots. The WTR 1 is configured to transfer the wafers, mainly between the tanks, and moves only in the areas of the tanks.

The DualLifter Robot 7 (hereinafter referred to as a Dual manipulator) is a manipulator configured to transfer a wet material. Each Dual manipulator may move in both directions between two fixed tanks corresponding thereto.

The four Dual manipulators of the semiconductor process device are respectively provided between the Tank1 and the Tank2 (only for transferring a material therebetween), between the Tank3 and the Tank4 (only for transferring a material therebetween), between the Tank5 and the Tank6 (only for transferring a material therebetween), and between the Tank7 and the Tank8 (only for transferring a material therebetween).

The semiconductor process device involved in the embodiments of the present disclosure processes a plurality of materials in a same batch of processes, and each material corresponds to one to-be-started task. For example, the materials may be wafers, one to-be-started task is used for processing of one wafer, and each to-be-started task includes a plurality of procedures during the processing of the wafer.

Illustratively, the plurality of procedures of the to-be-started task may be as follows: Shelf-PDO1/PDO2-WTC-IOBuffer-Tank3-Tank4-WTR-Tank5-Tank6-WTR-Tank1-Ta nk2-WTR-Tank7-Tank8-WTR-Dry-WTR-WTC-PDO1/PDO2-Shelf.

Specifically, reference may be made to the flowchart shown in FIG. 2 for the plurality of procedures included in the to-be-started task.

At step S1, the FR manipulator transfers the FOUP from the shelf to the PDO for mapping, and the FOUP door is opened.

At step S2, the WHR transfers the wafer from the FOUP on the PDO to the WTC. The to-be-started task may specify the PDO1 or the PDO2 to perform mapping alone.

At step S3, the FR manipulator moves the empty FOUP from the PDO back to the corresponding shelf in the stocker.

At step S4, the WTR moves the wafer from the WTC to the IOBuffer for a verification operation.

At step S5, all wafers are processed in the machine according to a factory-side recipe.

At step S6, after being processed, the wafer is sent to the drying tank for drying.

At step S7, the wafer is dried in the drying tank and is finally transferred out of the machine.

At step S8, the FR manipulator transfers the empty FOUP from the shelf to the PDO.

At step S9, after the process is completed, the WHR moves the wafer from the WTC to the FOUP on the PDO.

At step S 10, the FR manipulator moves the FOUP from the PDO back to the corresponding shelf in the stocker.

The task scheduling method provided in the embodiments of the present disclosure is at least applicable to the application scenario described below.

At present, the semiconductor process device needs to process a plurality of materials in a same batch of processes, and each material corresponds to one to-be-started task. Each to-be-started task includes a plurality of procedures during the processing of the material. Since the procedures of a started task are continuously completed, it may be the case that the started task and a to-be-started task are incompatible at a first moment, but are compatible at a second moment after the first moment as the progress of the procedures of the started task is updated.

Based on the existing technical solutions, a task, which is compatible with the started task and has waited for a longest time, is usually selected from a list of tasks waiting for being started. On such basis, on the one hand, the progress of the procedures of the started task is updated in real time as the started task is performed, but the process of determining whether the started task is compatible with a to-be-started task is not updated, which may cause incorrect determination, and prevent a task which could have been started from being started. On the other hand, planning of the to-be-started tasks cannot be carried out, such that accurate start moments of the to-be-started tasks cannot be obtained.

Therefore, based on the existing technical solutions, real-time optimization of task scheduling cannot be achieved, and resource waste is caused, resulting in low equipment production capacity.

Based on the above application scenario, the task scheduling method provided in the embodiments of the present disclosure is described in detail below.

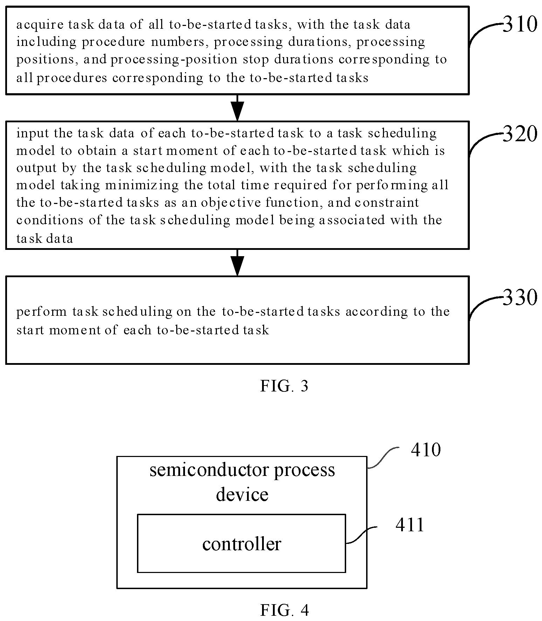

FIG. 3 is a flowchart illustrating a task scheduling method according to an embodiment of the present disclosure.

As shown in FIG. 3, the task scheduling method may include step 310 to step 330, in which a semiconductor process device processes a plurality of materials in a same batch of processes, each material corresponds to one to-be-started task, and each to-be-started task includes a plurality of procedures. Specifically, step 310 to step 330 are as follows.

At step 310, task data of all to-be-started tasks is acquired; and the task data includes procedure numbers, processing durations, processing positions, and processing-position stop durations corresponding to all procedures corresponding to the to-be-started tasks, a procedure number is a procedure code, a processing duration is the time required for completing each procedure, a processing position is a position of a material in the semiconductor process device when each procedure is performed, and a processing-position stop duration is a stop duration of a material at a corresponding processing position after each procedure is completed.

At step 320, the task data of each to-be-started task is input to a task scheduling model to obtain a start moment of each to-be-started task which is output by the task scheduling model; and the task scheduling model takes minimizing the total time required for performing all the to-be-started tasks as an objective function, and constraint conditions of the task scheduling model are associated with the task data.

At step 330, task scheduling is performed on the to-be-started tasks according to the start moment of each to-be-started task.

In the task scheduling method provided in the present disclosure, the task data, which include the procedure numbers, the processing durations, the processing positions, and the processing-position stop durations corresponding to all the procedures corresponding to the to-be-started tasks, is acquired; and the task data is input to the task scheduling model which takes minimizing the total time required for performing all the to-be-started tasks as the objective function and has the constraint condition associated with the task data, so as to obtain the start moment of each to-be-started task which is output by the task scheduling model. Here, all the to-be-started tasks are planned by taking minimizing the total processing time as an objective, the start moment of each to-be-started task can be obtained according to the task data, the starting of the tasks can be planned efficiently and orderly. Finally, task scheduling is performed on the to-be-started tasks according to the start moments, which can increase task completion efficiency, thereby improving equipment production capacity.

Step 310 to step 330 are respectively described below.

With respect to step 310

The task data of all the to-be-started tasks is acquired; and the task data includes the procedure numbers, the processing durations, the processing positions, and the processing-position stop durations corresponding to all the procedures corresponding to the to-be-started tasks.

The procedure numbers are the procedure codes, such as 1, 2, 3 ..., or a, b, c ....

The processing duration is the time required for completing each procedure, and the processing durations corresponding to different procedures are different; and the processing duration at each processing position is a preset value. For example, the processing duration at a PDO is a preset duration d from the opening of an FOUP door through the completion of a mapping process till the closing of the FOUP door. The processing duration at a shelf is 0, and the processing duration at the WTC is 0.

The processing position is the position of the material in the semiconductor process device when each procedure is performed; and the stop duration at each processing position is a preset value.

The processing-position stop duration is the stop duration of the material at the corresponding processing position after each procedure is completed.

The task data is described by taking the PDO as an example. The task data "2, 5s, PDO, 10s" indicates that the procedure number is 2, the processing duration is 5 seconds, the processing position is the PDO, and the processing-position stop duration is 10 seconds.

In one possible embodiment, in order to more accurately construct the task scheduling model, the semiconductor process device may be analyzed to specify possible procedures and flow which may occur in the device. Before step 310, the method further includes:

analyzing the semiconductor process device to obtain device information, with the device information at least including: hardware information of the semiconductor process device, the materials processed by the semiconductor process device, and a plurality of procedures included in the to-be-started tasks, and the device information being configured to construct the task scheduling model.

As for the hardware information of the semiconductor process device, the hardware information may determine setting of the procedures to a certain extent. As for the materials processed by the semiconductor process device, the processing procedures for different materials are different, so the materials processed by the semiconductor process device need to be determined. As for the plurality of procedures included in the to-be-started tasks, the plurality of procedures included in one to-be-started task may be different from those included in another to-be-started task, so the plurality of procedures included in each to-be-started task need to be determined for realizing accurate scheduling.

The device information is obtained by analyzing the semiconductor process device, and then the objective function and a constraint condition set are constructed according to the device information and the procedures of the to-be-started tasks. Thus, the task scheduling model can be constructed more accurately.

Specifically, the semiconductor process device may be a cleaning machine, the materials are wafers, and the processing positions include a shelf, a PDO, a WTC, an IOBuffer, a tank, and a WTR.

Here, in this embodiment, transportation (movement) resources are planned in the modeling process, that is, the manipulators belonging to the transportation (movement) resources are added to process paths of the materials (the wafers). By adding the manipulators to the process paths of the materials, the task scheduling model can be constructed more accurately.

With respect to step 320

At step 320, the task data is input to the task scheduling model, and the start moment of each to-be-started task is output. The task scheduling model takes minimizing the total time required for performing all the to-be-started tasks as the objective function, and the constraint conditions of the task scheduling model are associated with the task data.

In one possible embodiment, before step 320, the task scheduling method may further include:

constructing an objective function including a minimization function related to the time required for performing all the to-be-started tasks;
constructing a constraint condition set including constraint conditions related to the task data of all the to-be-started tasks; and
constructing the task scheduling model according to the objective function and the constraint condition set.

Specifically, the objective function may be as follows:

$$\min\left(\max\left(\sum_{i=1}^{O_h} LT_{hi}\right)\right) \quad (1)$$

where h is a material number, and $O=\{O_1, O_2, ..., O_n\}$ is a procedure set of each material; $O_h$ is the number of the procedures for a material h; $LT_{hi}$ is an end moment of an $i^{th}$ procedure of the material h; $\max\left(\sum_{i=1}^{O_h} LT_{hi}\right)$ denotes an end moment when all the procedures for a material processed last are completed, and min denotes a minimum value calculation, which is configured to find an earliest end moment when all the procedures of all the materials are completed. Thus, the formula (1) is configured to represent the minimization function related to the time required for performing all the to-be-started tasks.

Constructing the task scheduling model according to the objective function and the constraint condition set may specifically include:

performing mathematical modeling on the objective function and the constraint condition set based on mixed integer programming (MIP), so as to obtain the task scheduling model.

The MIP refers to an integer programming problem in which part of decision variables are limited to integers.

The mathematical modeling process specifically includes: constructing variables, i.e., the task data, and generating constraint conditions and the objective function based on the variables. Then, a task scheduling model obtained by construction is solved with a solver, and a finally output variable result is a variable optimal solution meeting the constraint conditions.

The constraint conditions include:

the sum of a start moment (i.e., a value corresponding to the moment), a processing duration, and a processing-position stop duration of each procedure of a material is equal to an end moment (i.e., a value corresponding to the moment) of each procedure of the material;

a difference between the end moment (i.e., a value corresponding to the moment) of the i$^{th}$ procedure of the material and a processing-position stop duration of the i$^{th}$ procedure of the material is equal to a start moment (i.e., a value corresponding to the moment) of an (i+1)$^{th}$ procedure of the material;

for a same target processing position, only one material is allowed to be processed at the corresponding target processing position;

if the i$^{th}$ procedure of the material is performed at the target processing position before a j$^{th}$ procedure of another material, the difference between the end moment of the i$^{th}$ procedure of the material and the processing-position stop duration of the i$^{th}$ procedure of the material is less than or equal to a start moment of the j$^{th}$ procedure of another material; and

i and j are the procedure numbers and are positive integers; and the start moments, the processing durations, the processing-position stop durations, and the end moments are all greater than or equal to zero.

The constraint conditions are respectively explained below.

Firstly, in order to accurately calculate the end moment of each procedure, the stop duration is added to a general relationship that the sum of the start moment and the processing duration is equal to the end moment. The addition is made due to the constraint of a manipulator. Since there is only one manipulator in a process area, the manipulator is transferring a material A when the material A is taken away by the manipulator after being processed in a tank, so a material B cannot be placed in the tank immediately. Therefore, an actual release time of the tank is not the time when the material A is taken away after being processed, but is the time when the material A is transferred to a next processing position.

Taking the procedures "Shelf-PDO1/PDO2-WTC-IOBuffer-Tank3-Tank4-WTR-Tank5-Tank6-WTR-Tank1-Tank2-WTR-Tank7-Tank8-WTR-Dry-WTR-WTC-PDO1/PDO2-Shelf" as an example, the WTR is transferring the material A when the material A is taken away by the WTR after being processed in the Tank4, so the material B cannot be placed in the Tank4 immediately.

That is, from the start moment of the procedure, a real end of the procedure at the corresponding processing position is after the processing duration, and the stop duration of the material at the processing position after the procedure is completed.

Therefore, a first constraint condition is that the sum of the start moment, the processing duration, and the processing-position stop duration of each procedure of the material is equal to the end moment of each procedure of the material. In this way, the end moment of each procedure can be calculated accurately. Specifically, the first constraint condition may be as follows:

$$ET_{hi} + d_{hi} + stop_{hi} = LT_{hi}, h \in N, i \in O_n \qquad (2)$$

$ET_{hi}$: a start moment of the i$^{th}$ procedure of the material h;
$d_{hi}$: a processing duration of the i$^{th}$ procedure of the material h;
$stop_{hi}$: the processing-position stop duration after the i$^{th}$ procedure of the material h is completed;
$LT_{hi}$: the end moment of the i$^{th}$ procedure of the material h; and
$N = \{1,2,..., n\}$: a material set.

The above formula represents that the sum of the start moment of the $i^{th}$ procedure of the material h, the processing duration of the $i^{th}$ procedure of the material h, and the processing-position stop duration after of the $i^{th}$ procedure of the material h is completed is equal to the end moment of the $i^{th}$ procedure of the material h.

Secondly, since the start moment of the $i^{th}$ procedure of the material, the $i^{th}$ procedure of the material is actually completed after the processing duration of the $i^{th}$ procedure of the material, at this time, the material is in a state available to be subjected to an $(i+1)^{th}$ procedure of the material, that is, an actual end moment of the $i^{th}$ procedure of the material is equal to the sum of the start moment of the $i^{th}$ procedure of the material and the processing duration of the $i^{th}$ procedure of the material, that is, the actual end moment of the $i^{th}$ procedure of the material is equal to a difference between the end moment of the $i^{th}$ procedure of the material and the processing-position stop duration of the $i^{th}$ procedure of the material.

Since the end moment of the $i^{th}$ procedure of the material is equal to the sum of the start moment of the $i^{th}$ procedure of the material, the processing duration of the $i^{th}$ procedure of the material, and the processing-position stop duration of the $i^{th}$ procedure of the material, a start moment of the $(i+1)^{th}$ procedure of the material needs to be obtained by subtracting the processing-position stop duration of the $i^{th}$ procedure of the material from the end moment of the $i^{th}$ procedure of the material.

Therefore, the second constraint condition is that the difference between the end moment of the $i^{th}$ procedure of the material and the processing-position stop duration of the $i^{th}$ procedure of the material is equal to the start moment of the $(i+1)^{th}$ procedure of the material.

Specifically, the second constraint condition may be as follows:

$$ET_{hi+1} = LT_{hi} - stop_{hi}, h \in N, i \in O_n \qquad (3)$$

$ET_{hi+1}$: the start moment of the $(i+1)^{th}$ procedure of the material h;
$stop_{hi}$: the processing-position stop duration after the $i^{th}$ procedure of the material h is completed;
$LT_{hi}$: the end moment of the $i^{th}$ procedure of the material h; and
$N = \{1,2,..., n\}$: a material set.

The above formula represents that the difference between the end moment of the $i^{th}$ procedure of the material and the processing-position stop duration of the $i^{th}$ procedure of the material is equal to the start moment of the $(i+1)^{th}$ procedure of the material.

Taking the procedures "Shelf-PDO1/PDO2-WTC-IOBuffer-Tank3-Tank4-WTR-Tank5-Tank6-WTR-Tank1-Tank2-WTR-Tank7-Tank8-WTR-Dry-WTR-WTC-PDO1/PDO2-Shelf" as an example, the difference between the end moment of the procedure of the material in the Tank7 and the processing-position stop duration of the procedure of the material in the Tank7 is equal to the start moment of the procedure of the material in the Tank 8.

Then, in order to ensure that the procedures do not conflict with each other, it needs to be limited that the procedures of two materials are in only one chronological order at one processing position. That is, for a target processing position k, either the procedure of the material h precedes the procedure of a material l, or the procedure of the material l precedes the procedure of the material h.

Therefore, a third constraint condition is that, for the same target processing position, only one material is allowed to be processed at the corresponding target processing position.

Specifically, the third constraint condition may be as follows:

$$x_{khilj} + x_{kljhi} = 1, h, l \in N, i, j \in O_n, k \in K \qquad (4)$$

where

$$X_{khilj} = \begin{cases} 1, \text{ if the } i^{th} \text{ procedure of the material h is performed at the processing position k before the } j^{th} \text{procedure of the material l} \\ 0, \text{ otherwise} \end{cases}$$

$N = \{1,2,..., n\}$: a material set;
$K = \{1,2,..., n\}$: a set of the processing positions of the materials; and $x_{khilj}$ denotes that the $i^{th}$ procedure of the material h is performed at the processing position k before the $j^{th}$ procedure of the material l; $x_{kljhi}$ denotes that the $j^{th}$ procedure of the material l is performed at the processing position k before the $i^{th}$ procedure of the material h; and since the sum of $x_{khilj}$ and $x_{kljhi}$ is 1, one of $x_{khilj}$ and $x_{kljhi}$ is 0, and the other one is 1. Thus, for the same target processing position, only one material is allowed to be processed at the corresponding target processing position.

Then, in order to ensure that the to-be-started tasks do not conflict with each other, it needs to be limited that the start moment of a next procedure of the material does not precede the actual end moment of a previous procedure of the material contiguous to the next procedure of the material. Therefore, if the ith procedure of the material is performed at the target processing position before the jth procedure of another material, the actual end moment of the ith procedure of the material is less than or equal to the start moment of the jth procedure of another material. As stated above, the actual end moment of the ith procedure of the material is equal to the difference between the end moment of the ith procedure of the material and the processing-position stop duration of the ith procedure of the material, so a fourth constraint condition may be obtained as follows.

The fourth constraint condition is that, if the ith procedure of the material is performed at the target processing position before jth procedure of another material, the difference between the end moment of the ith procedure of the material and the processing-position stop duration of the ith procedure of the material is less than or equal to the start moment of the jth procedure of another material. Specifically, the fourth constraint condition may be as follows:

$$LT_{hi} - stop_{hi} \leq ET_{lj} + M\left(1 - x_{khilj}\right), h, l \in N, i, j \in O_n, k \in K \qquad (5)$$

$N = \{1, 2, ..., n\}$: a material set; and

M is a very large positive number, and is configured to realize model linearization. Illustratively, M may be the total time for completing the processing of a preset number of materials, and the preset number is far greater than the number of the materials actually to be processed.

If the ith procedure of the material h is performed at the processing position k before the jth procedure of the material l, $x_{khilj}$ is 1, and the right side of the inequality of the fourth constraint condition is $ET_{lj}$.

Therefore, the above inequality represents that, if the ith procedure of the material h is performed at the processing position k before the jth procedure of the material l, the difference between the end moment of the ith procedure of the material h and the processing-position stop duration after the ith procedure of the material h is completed is less than or equal to the start moment of the jth procedure of the material l.

If the ith procedure of the material h is not performed at the processing position k before the jth procedure of the material l, $x_{khilj}$ is 0, the right side of the inequality of the fourth constraint condition is a very large positive number, and the inequality relation naturally holds.

Finally, the procedure numbers are positive integers, and the start moments, the processing durations, the processing-position stop durations, and the end moments are greater than or equal to zero.

Therefore, a fifth constraint condition is that i and j are the procedure numbers and are positive integers; and the start moments, the processing durations, the processing-position stop durations, and the end moments are all greater than or equal to zero.

Specifically, the fifth constraint condition may be as follows:

$$stop_{hi}, \quad d_{hi}, \quad ET_{hi}, \quad LT_{hi} \geq 0 \qquad (6)$$

The above formula represents the constraint of values of the variables, that is, i, j, the start moments, the processing durations, the stop durations, and the end moments are positive integers.

In addition, considering the operation of the WTR in an actual process, the procedure-position stop duration before the WTR needs to be limited. Since there is only one WTR in the process area, the WTR is transferring the material A when the material A is taken away by the WTR after being processed in a tank, so the material B cannot be placed in the tank immediately. Therefore, the actual release time of the tank is not the time when the material A is taken away after being processed, but is the time when the material A is transferred to a next processing position.

Therefore, the above constraint conditions may further include:

a sixth constraint condition, which is that, if a processing position of the (i+1)th procedure of the material is the WTR, the processing-position stop duration of the ith procedure of the material is an operation duration of the WTR; and

if the processing position of the (i+1)th procedure of the material is not the WTR, the processing-position stop duration of the ith procedure of the material is 0.

If the processing position of the (i+1)th procedure of the material is the WTR, the processing-position stop duration after the ith procedure of the material is completed is the operation duration of the WTR; and if the processing position of the (i+1)th procedure of the material is not the WTR, the processing-position stop duration after the ith procedure of the material is completed is 0.

Taking the procedures "Shelf-PDO1/PDO2-WTC-IOBuffer-Tank3-Tank4-WTR-Tank5-Tank6-WTR-Tank1-Ta nk2-WTR-Tank7-Tank8-WTR-Dry-WTR-WTC-PDO1/PDO2-Shelf" as an example, if the processing position of the (i+1)$^{th}$ procedure of the material is the WTR, the stop duration at the processing position after the i$^{th}$ procedure of the material is completed, i.e., the stop duration at the Tank4, or the Tank6, or the Tank2, or the Tank8, is the operation duration of the WTR; and if the processing position of the (i+1)$^{th}$ procedure of the material is not the WTR, such stop duration is 0.

Thus, an actual release duration of the processing position where the i$^{th}$ procedure of the material is performed is described by controlling the value of the stop duration, so that the actual release duration of the processing position can be accurately limited.

Specifically, the sixth constraint condition may be as follows:

$$stop_{hi} = d_{hi+1} \, if \, i+1 \, is \, WTR \, else \, 0 \qquad (7)$$

d$_{hi}$: the processing duration of the i$^{th}$ procedure of the material h; and
stop$_{hi}$: the processing-position stop duration after the i$^{th}$ procedure of the material h is completed.

The above formula represents that, if the processing position of the (i+1)$^{th}$ procedure of the material h is the WTR, the processing-position stop duration after the i$^{th}$ procedure of the material h is completed is the operation duration of the WTR; and if the processing position of the (i+1)$^{th}$ procedure of the material h is not the WTR, the processing-position stop duration after the i$^{th}$ procedure of the material h is completed is 0.

In one possible embodiment, step 320 may specifically include:
calculating the task scheduling model to obtain the start moment of each to-be-started task and the minimum total time required for performing all the to-be-started tasks.

Illustratively, a task which is being performed in the machine is a task 1 including a plurality of procedures, at this time, a task 2 also includes a plurality of procedures, and the procedures of the task 1 and the procedures of the task 2 partially overlap, so the task 1 is incompatible with the task 2. By obtaining a result of the variable ET$_{hi}$ from a solution result model of the task scheduling model, the time when a first procedure of the task 2 is to be started may be obtained, that is, a start moment of the task 2 may be obtained.

Thus, by calculating the task scheduling model, the start moment of each to-be-started task can be obtained; and even if a process path of a task which is in the machine conflicts with a process path of a task which is to enter the machine, a specific start moment can also be obtained, and the obtained start moment does not cause a deadlock problem. Since a movement situation of each task in the device can be obtained through the task scheduling model, the start moments of the tasks obtained based on the task scheduling model cannot cause a deadlock of the tasks. The deadlock refers to a logjam caused by a plurality of procedures competing for resources during the operation of the procedures. When the procedures are in the deadlock, none of the procedures can progress further without external force. The task scheduling method according to the embodiments of the present disclosure does not cause the deadlock problem.

With respect to step 330

At step 330, task scheduling is performed on the to-be-started tasks according to the start moment of each to-be-started task.

The start moment of each to-be-started task can be obtained through the solution result model of the task scheduling model, so that a start moment of a first procedure of each task, i.e., the start moment of each task, can be determined.

According to the embodiments of the present disclosure, the problem of finding the start moments of the tasks is efficiently solved with the MIP model which takes minimizing the processing time of the maximum materials as an objective, and all the to-be-started tasks are planned by taking maximizing the production capacity as an objective. The variable ET$_{hi}$ in the model denotes the start moment of the i$^{th}$ procedure of the material h, so the time when the 0$^{th}$ procedure of each material is started is the start moment of the material. The variable ET$_{hi}$ is one of the results output from the solution model. Moreover, the deadlock problem caused by the starting of the tasks can be avoided, and the production efficiency can also be greatly increased.

In summary, according to the embodiments of the present disclosure, the task data, which include the procedure numbers, the processing durations, the processing positions, and the processing-position stop durations corresponding to all the procedures corresponding to the to-be-started tasks, is acquired; and the task data is input to the task scheduling model which takes minimizing the total time required for performing all the to-be-started tasks as the objective function and has the constraint conditions associated with the task data, and the start moment of each to-be-started task is output. Here, all the to-be-started tasks are planned by taking minimizing the total processing time as the objective, the start moment of each to-be-started task can be obtained according to the task data, the starting of the tasks can be planned efficiently and orderly. Finally, task scheduling is performed on the to-be-started tasks according to the start moments, which can increase the task completion efficiency, thereby improving the equipment production capacity.

It should be noted that each method embodiment is described as a combination of a series of actions for simplifying the description, but it should be understood by those of ordinary skill in the art that the embodiments of the present disclosure are not limited to the described orders of the actions because some steps according to the embodiments of the present disclosure may be performed in other orders or may be performed simultaneously. Further, it should be further understood by those of ordinary skill in the art that the embodiments described in the specification are preferable embodiments and the actions therein are not necessarily required by the embodiments of the present disclosure.

Referring to FIG. 4, a block diagram of a semiconductor process device according to an embodiment of the present disclosure is shown. The semiconductor process device processes a plurality of materials in a same batch of processes, each material corresponds to one to-be-started task, and each to-be-started task includes a plurality of procedures. The semiconductor process device 410 includes a controller 411.

The controller 411 is configured to acquire task data of all to-be-started tasks. The task data includes procedure numbers, processing durations, processing positions, and processing-position stop durations corresponding to all procedures corresponding to the to-be-started tasks, a procedure number is a procedure code, a processing duration is the time required for completing each procedure, a processing position is a position of a material in the semiconductor process device when each procedure is performed, and a processing-position stop duration is a stop duration of a material at a corresponding processing position after each procedure is completed.

The controller 411 is configured to input the task data of each to-be-started task to a task scheduling model to obtain a start moment of each to-be-started task which is output by the task scheduling model. The task scheduling model takes minimizing the total time required for performing all the to-be-started tasks as an objective function, and constraint conditions of the task scheduling model are associated with the task data.

The controller 411 is configured to perform task scheduling on the to-be-started tasks according to the start moment of each to-be-started task.

In an alternative embodiment of the present disclosure, the controller 411 is further configured to:

construct an objective function including a minimization function related to the time required for performing all the to-be-started tasks;
construct a constraint condition set including constraint conditions related to the task data of all the to-be-started tasks; and
construct the task scheduling model according to the objective function and the constraint condition set.

In an alternative embodiment of the present disclosure, the constraint conditions include:

the sum of a start moment, a processing duration, and a processing-position stop duration of each procedure of a material is equal to an end moment of each procedure of the material;
a difference between an end moment of an $i^{th}$ procedure of the material and a processing-position stop duration of the $i^{th}$ procedure of the material is equal to a start moment of an $(i+1)^{th}$ procedure of the material;
for a same target processing position, only one material is allowed to be processed at the corresponding target processing position;
if the $i^{th}$ procedure of the material is performed at the target processing position before a $j^{th}$ procedure of another material, the difference between the end moment of the $i^{th}$ procedure of the material and the processing-position stop duration of the $i^{th}$ procedure of the material is less than or equal to a start moment of the $j^{th}$ procedure of another material;
and i and j are the procedure numbers and are positive integers; and the start moments, the processing durations, the processing-position stop durations, and the end moments are all greater than or equal to zero.

In an alternative embodiment of the present disclosure, the semiconductor process device is a cleaning machine, the materials are wafers, and the processing positions include a shelf, a PDO, a WTC, an IOBuffer, a tank, and a WTR.

In an alternative embodiment of the present disclosure, the constraint conditions further include:

if a processing position of the $(i+1)^{th}$ procedure of the material is WTR, the processing-position stop duration of the $i^{th}$ procedure of the material is an operation duration of the WTR; and
if the processing position of the $(i+1)^{th}$ procedure of the material is not the WTR, the processing-position stop duration of the $i^{th}$ procedure of the material is 0.

In an alternative embodiment of the present disclosure, the controller 411 is specifically configured to input the task data to the task scheduling model to obtain the start moment of each to-be-started task and the minimum total time required for performing all the to-be-started tasks, which are obtained through a calculation of the task scheduling model.

In an alternative embodiment of the present disclosure, the controller 411 is further configured to analyze the semiconductor process device to obtain device information. The device information at least includes: hardware information of the semiconductor process device, the materials processed by the semiconductor process device, and a plurality of procedures included in the to-be-started tasks; and the device information is configured to construct the task scheduling model.

In an alternative embodiment of the present disclosure, the controller 411 is specifically configured to perform mathematical modeling on the objective function and the constraint condition set based on MIP to obtain the task scheduling model.

In an alternative embodiment of the present disclosure, the semiconductor process device 410 further includes: a solver, which is configured to perform a calculation based on the task scheduling model to obtain the start moment of each to-be-started task and the minimum total time required for performing all the to-be-started tasks.

In summary, according to the embodiments of the present disclosure, the task data, which include the procedure numbers, the processing durations, the processing positions, and the processing-position stop durations corresponding to all the procedures corresponding to the to-be-started tasks, is acquired; and the task data is input to the task scheduling model which takes minimizing the total time required for performing all the to-be-started tasks as the objective function and has the constraint conditions associated with the task data, so as to obtain the start moment of each to-be-started task which is output by the task scheduling model. Here, all the to-be-started tasks are planned by taking minimizing the total processing time as the objective, the start moment of each to-be-started task can be obtained according to the task data, the starting of the tasks can be planned efficiently and orderly. Finally, task scheduling is performed on the to-be-started tasks according to the start moments, which can increase task completion efficiency, thereby improving equipment production capacity.

As for the device embodiments, since the device embodiments are substantially similar to the method embodiments, the device embodiments are described relatively simply, and reference may be made to part of the description of the method embodiments for relevant contents.

An embodiment of the present disclosure further provides an electronic device, including: a processor, a memory, and a computer program which is stored on the memory and is executable on the processor. When being executed by the processor, the computer program causes the processor to perform each step of the task scheduling method described above, and can produce the same technical effects, which will not be repeated here.

An embodiment of the present disclosure further provides a computer-readable storage medium having a computer program stored thereon. When being executed by a processor, the computer program causes the processor to perform each step of the task scheduling method described above, and can produce the same technical effects, which will not be repeated here.

As for the device embodiments, since the device embodiments are substantially similar to the method embodiments, the device embodiments are described relatively simply, and reference may be made to part of the description of the method embodiments for relevant contents.

The embodiments in the present specification are all described in a progressive manner, and each embodiment focuses on the differences from the other embodiments; and for the same or similar contents of the embodiments, reference may be made to each other.

It should be understood by those of ordinary skill in the art that the embodiments of the present disclosure may be implemented as a method, a device, or a computer program product. Accordingly, the embodiments of the present disclosure may take the form of embodiments involving hardware alone, embodiments involving software alone, or embodiments combining software and hardware. Furthermore, the embodiments of the present disclosure may take the form of a computer program product, which is implemented on one or more computer-usable storage media (including, but not limited to, magnetic disks, Compact Disc Read-Only Memories (CD-ROMs), and optical storage devices) containing computer-usable program codes.

The embodiments of the present disclosure are described with reference to the flowcharts and/or the block diagrams illustrating the method, the terminal device (system), and the computer program product according to the embodiments of the present disclosure. It should be understood that each process of the flowcharts and/or each block of the block diagrams, and a combination of processes of the flowcharts and/or a combination of the blocks of the block diagrams may be implemented by computer program instructions. The computer program instructions may be provided for a general purpose computer, a special purpose computer, an embedded processor, or processors of other programmable data processing terminal devices to produce a machine, such that the instructions executed by the computers or the processors of the other programmable data processing terminal devices can generate a device configured to perform a function or functions specified in one or more processes of the flowcharts and/or one or more blocks of the block diagrams.

The computer program instructions may also be stored in a computer-readable memory capable of guiding the computers or the other programmable data processing terminal devices to operate in a particular manner, such that the instructions stored in the computer-readable memory can produce a product including an instruction device configured to perform a function or functions specified in one or more processes of the flowcharts and/or one or more blocks of the block diagrams.

The computer program instructions may also be loaded to the computers or the other programmable data processing terminal devices, so as to cause the computers or the other programmable data processing terminal devices to perform a series of steps to produce the processing realized by the computers, such that the instructions executed on the computers or the other programmable terminal devices can provide steps for performing a function or functions specified in one or more processes of the flowcharts and/or one or more blocks of the block diagrams.

Although the preferred embodiments of the present disclosure are described, those of ordinary skill in the art can make other variations and modifications to the embodiments once they learn of the basic inventive concept. Therefore, the appended claims are intended to be interpreted as including the preferred embodiments and all the variations and modifications that fall within the scope of the embodiments of the present disclosure.

Finally, it should be further noted that the relational terms such as "first" and "second" herein are only used to distinguish one entity or action from another entity or action, and do not necessarily require or imply that such relationship or order actually exists between the entities or actions. Moreover, the terms "includes", "comprises" or any other variation thereof are intended to indicate a non-exclusive inclusion, so that a process, method, article, or terminal device, which includes a series of elements, does not only include those listed elements but also include other elements which are not explicitly listed, or the elements inherent in such process, method, article, or terminal device. If there are no more limitations, limiting an element by "including a..." does not exclude the existence of other identical elements in the process, method, article, or terminal device which includes the element.

The task scheduling method and the semiconductor process device provided in the present disclosure are described in detail above. The principle and the implementations of the present disclosure are illustrated by specific examples, and the above description of the embodiments is only used to help understand the method and the core idea of the present disclosure. Meanwhile, those of ordinary skill in the art can make a change in the specific embodiments and the application range according to the idea of the present disclosure. In summary, the contents of the specification should not be interpreted as a limitation to the present disclosure.

## Claims

1. A task scheduling method applied to a semiconductor process device, wherein the semiconductor process device processes a plurality of materials in a same batch of processes, each of the materials corresponds to one to-be-started task, each of to-be-started tasks comprises a plurality of procedures, and the task scheduling method comprises:

    acquiring task data of all the to-be-started tasks; wherein the task data comprises procedure numbers, processing durations, processing positions, and processing-position stop durations corresponding to all procedures corresponding to the to-be-started tasks, a procedure number is a procedure code, a processing duration is time required for completing each of the procedures, a processing position is a position of a material in the semiconductor process device when each of the procedures is performed, and a processing-position stop duration is a stop duration of a material at a corresponding processing position after each of the procedures is completed;

    inputting the task data of each of the to-be-started tasks to a task scheduling model to obtain a start moment of each of the to-be-started tasks which is output by the task scheduling model; wherein the task scheduling model takes minimizing total time required for performing all the to-be-started tasks as an objective function, and constraint conditions of the task scheduling model are associated with the task data; and

    performing task scheduling on the to-be-started tasks according to the start moment of each of the to-be-started tasks.

2. The method of claim 1, wherein before inputting the task data of each of the to-be-started tasks to the task scheduling model to obtain the start moment of each of the to-be-started tasks which is output by the task scheduling model, the method further comprises:

    constructing the objective function comprising a minimization function related to time required for performing all the to-be-started tasks;

    constructing a constraint condition set comprising constraint conditions related to the task data of all the to-be-started tasks; and

    constructing the task scheduling model according to the objective function and the constraint condition set.

3. The method of claim 2, wherein the constraint conditions comprise:

a sum of a start moment, a processing duration, and a processing-position stop duration of each procedure of a material is equal to an end moment of each procedure of the material;

a difference between an end moment of an i$^{th}$ procedure of the material and a processing-position stop duration of the i$^{th}$ procedure of the material is equal to a start moment of an (i+1)$^{th}$ procedure of the material;

for a same target processing position, only one material is allowed to be processed at the corresponding target processing position;

if the i$^{th}$ procedure of the material is performed at the target processing position before a j$^{th}$ procedure of another material, the difference between the end moment of the i$^{th}$ procedure of the material and the processing-position stop duration of the i$^{th}$ procedure of the material is less than or equal to a start moment of the j$^{th}$ procedure of another material; and

i and j are the procedure numbers and are positive integers; and the start moments, the processing durations, the processing-position stop durations, and the end moments are all greater than or equal to zero.

4. The method of claim 1, wherein the semiconductor process device is a cleaning machine, the materials are wafers, and the processing positions comprise a wafer holder, a scanning module, a temporary storage module, a verification module, a processing module, and a wafer transferring manipulator.

5. The method of claim 4, wherein the constraint conditions further comprise:

   if a processing position of an (i+1)$^{th}$ procedure of the material is the wafer transferring manipulator, the processing-position stop duration of an i$^{th}$ procedure of the material is an operation duration of the wafer transferring manipulator; and

   if the processing position of the (i+1)$^{th}$ procedure of the material is not the wafer transferring manipulator, the processing-position stop duration of the i$^{th}$ procedure of the material is 0.

6. The method of claim 1, wherein inputting the task data to the task scheduling model to obtain the start moment of each of the to-be-started tasks which is output by the task scheduling model comprises:

   inputting the task data to the task scheduling model to obtain the start moment of each of the to-be-started tasks and a minimum total time required for performing all the to-be-started tasks, which are obtained through a calculation of the task scheduling model.

7. The method of claim 1 or 2, wherein before acquiring the task data of all the to-be-started tasks, the method further comprises:

   analyzing the semiconductor process device to obtain device information; wherein the device information at least comprises: hardware information of the semiconductor process device, the materials processed by the semiconductor process device, and a plurality of procedures included in the to-be-started tasks, and the device information is configured to construct the task scheduling model.

8. The method of claim 2, wherein constructing the task scheduling model according to the objective function and the constraint condition set comprises:

   performing mathematical modeling on the objective function and the constraint condition set based on mixed integer programming, so as to obtain the task scheduling model.

9. A semiconductor process device, wherein the semiconductor process device processes a plurality of materials in a same batch of processes, each of the materials corresponds to one to-be-started task, each of to-be-started tasks comprises a plurality of procedures, and the semiconductor process device comprises:
   a controller, which is configured to:

   acquire task data of all the to-be-started tasks; wherein the task data comprises procedure numbers, processing durations, processing positions, and processing-position stop durations corresponding to all the procedures corresponding to the to-be-started tasks, a procedure number is a procedure code, a processing duration is time required for completing each of the procedures, a processing position is a position of a material in the semiconductor process device when each of the procedures is performed, and a processing-position stop duration is a stop duration of a material at a corresponding processing position after each of the procedures is completed;

   input the task data of each of the to-be-started tasks to a task scheduling model to obtain a start moment of each of the to-be-started tasks which is output by the task scheduling model; wherein the task scheduling model takes minimizing total time required for performing all the to-be-started tasks as an objective function, and constraint conditions of the task scheduling model are associated with the task data; and
perform task scheduling on the to-be-started tasks according to the start moment of each of the to-be-started tasks.

10. The semiconductor process device of claim 9, further comprising:
a solver, which is configured to perform a calculation based on the task scheduling model to obtain the start moment of each of the to-be-started tasks and a minimum total time required for performing all the to-be-started tasks.

| acid process tank | water tank | acid process tank | water tank | acid process tank | water tank | acid process tank | water tank | drying process tank |

$1$

$2$ | $41$ | $51$

$42$ | $52$

$3$

$6$

stocker and FoupRobot

$7$ $7$ $7$ $7$

FIG. 1

S1, FOUP carrying wafer

| Shelf | | PDO | | WTC | S4 | IOBuffer | S5 | Tank | S6 | Dry |

S3, empty FOUP

S2

S8, empty FOUP

S9

S10, FOUP carrying wafer

S7

FIG. 2

acquire task data of all to-be-started tasks, with the task data including procedure numbers, processing durations, processing positions, and processing-position stop durations corresponding to all procedures corresponding to the to-be-started tasks ⟋310

input the task data of each to-be-started task to a task scheduling model to obtain a start moment of each to-be-started task which is output by the task scheduling model, with the task scheduling model taking minimizing the total time required for performing all the to-be-started tasks as an objective function, and constraint conditions of the task scheduling model being associated with the task data ⟋320

perform task scheduling on the to-be-started tasks according to the start moment of each to-be-started task ⟋330

FIG. 3

semiconductor process device ⟋ 410

controller ⟋ 411

FIG. 4

# INTERNATIONAL SEARCH REPORT

| International application No. |
| --- |
| **PCT/CN2022/134416** |

| **A.** | **CLASSIFICATION OF SUBJECT MATTER** |
| --- | --- |

G06Q10/06(2023.01)i;G06Q50/04(2012.01)i;H01L21/67(2006.01)i

According to International Patent Classification (IPC) or to both national classification and IPC

| **B.** | **FIELDS SEARCHED** |
| --- | --- |

Minimum documentation searched (classification system followed by classification symbols)

G06Q10/-; G06Q50/-; H01L21/-

Documentation searched other than minimum documentation to the extent that such documents are included in the fields searched

Electronic data base consulted during the international search (name of data base and, where practicable, search terms used)

CNTXT, WPABSC, ENTXTC, VEN, ENTXT, IEEE, CNKI, 互联网检索, Search on Internet: 西安北方华创微电子装备有限公司, 北京北方华创微电子装备有限公司, 半导体, 物料, 原料, 晶圆, 晶片, 任务, 工作, 工序, 步骤, 流程, 过程, 顺序, 调度, 模型, 时间, 时长, 短, 目标函数, 约束条件, semicon, semiconductor, semi-conductor, material?, wafer, task?, job, workstage, process, procedure, sequence, schedule, model, time, duration, cost, function, constraint, condition

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| PX | CN 114462781 A (XI'AN NAURA MICROELECTRONICS EQUIPMENT CO., LTD. et al.) 10 May 2022 (2022-05-10) claims 1-10 | 1-10 |
| X | CN 112987674 A (BEIJING NAURA MICROELECTRONICS EQUIPMENT CO., LTD.) 18 June 2021 (2021-06-18) description, paragraphs [0019]-[0069] | 1-10 |
| A | CN 111680877 A (HANGZHOU CHUANHUA INTELLIGENT MANUFACTURING TECHNOLOGY CO., LTD.) 18 September 2020 (2020-09-18) entire document | 1-10 |
| A | CN 112884321 A (TONGJI UNIVERSITY) 01 June 2021 (2021-06-01) entire document | 1-10 |
| A | US 2017337492 A1 (IBM) 23 November 2017 (2017-11-23) entire document | 1-10 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **16 February 2023** | **22 February 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

## INTERNATIONAL SEARCH REPORT
### Information on patent family members

International application No.

**PCT/CN2022/134416**

| Patent document cited in search report | | | Publication date (day/month/year) | Patent family member(s) | | | Publication date (day/month/year) |
|---|---|---|---|---|---|---|---|
| CN | 114462781 | A | 10 May 2022 | None | | | |
| CN | 112987674 | A | 18 June 2021 | CN | 112987674 | B | 17 September 2021 |
| | | | | WO | 2022227975 | A1 | 03 November 2022 |
| CN | 111680877 | A | 18 September 2020 | None | | | |
| CN | 112884321 | A | 01 June 2021 | None | | | |
| US | 2017337492 | A1 | 23 November 2017 | None | | | |

Form PCT/ISA/210 (patent family annex) (July 2022)